# EUROPÄISCHE PATENTANMELDUNG

(11) **EP 0 580 567 A1**
(43) Veröffentlichungstag der Anmeldung: **26.01.1994**
(21) Anmeldenummer: 93890143.6
(22) Anmeldetag: 21.07.1993
(51) Int. Cl.: H04B 10/20, H03F 3/08

(54) **Empfänger für ein optisches Übertragungsnetzwerk**

(30) Priorität: 21.07.1992 AT 1491/92
(71) Anmelder: Alcatel Austria Aktiengesellschaft, A-1210 Wien (AT)
(72) Erfinder: Hahn, Alois, A-1210 Wien (AT); Hiebeler, Markus, Dipl.-Ing., A-1050 Wien (AT); Hirn, Richard, Dipl.-Ing., A-1200 Wien (AT); Oster, Martin, Dipl.-Ing., A-1120 Wien (AT)
(74) Vertreter: Pohl, Herbert, Dipl.-Ing

(57) **Zusammenfassung**

Empfänger für ein optisches Übertragungsnetzwerk mit einer Anzahl von Endstellen und einer Zentralstelle, an die wenigstens ein Lichtwellenleiter angeschlossen ist, von welchem ausgehend über wenigstens einen Strahlenteiler und weitere Lichtwellenleiter Endstellen angeschlossen sind, von denen jede mit einem Sender und einem Empfänger für optische Binärsignale versehen sind, wobei der Empfänger der Zentralstelle eine Wechselspannungs-Koppelstufe aufweist. Um den Betrieb eines solchen Netzwerkes mit kurzen Synchronisiersignalen zu ermöglichen, ist vorgesehen, daß die Wechselspannungs-Koppelstufe des Empfängers ein Zeitglied (9) mit veränderbarer Zeitkonstante aufweist.

## Beschreibung

Die Erfindung betrifft einen Empfänger für ein optisches Übertragungsnetzwerk mit einer Zentralsteile, an die wenigstens ein Lichtwellenleiter angeschlossen ist, an welchen über wenigstens einen Strahlenteiler und weitere Lichtwellenleiter eine Anzahl von mit jeweils einem Sender und einem Empfänger für optische Binärsignale versehene Endstellen angeschlossen sind.

In herkömmlichen optischen Übertragungsstrecken, in denen kontinuierliche Punkt - zu- Punkt - Übertragungen stattfindet, gibt es nur langsame und stetige Änderungen der Amplitude und der Phasenlage des empfangenden Signals. Diese Änderungen werden durch Änderung der optischen Ausgangsleistung der Lichtquellen und schwankende Dämpfung auf der Übertragungsstrecke bzw.- durch Phasenschwankungen des Senders und Laufzeitänderungen des Lichtsignals verursacht. Weil das optische Signal unipolar, also nicht symmetrisch ist, bringt jede Amplitudenänderung auch eine Veränderung des Mittelwerts und damit der Lage der optimalen Entscheidungsschwelle mit sich.

Herkömmliche optische Empfänger kompensieren Schwankungen der Empfangsamplitude mit einer geregelten Verstärkerstufe (AGC). Wegen der Stetigkeit des Eingangssignals werden keine besonderen Anforderungen an das Einschwingverhalten dieser Regelstufe gestellt. Obwohl während der Einschwingzeit nach Beginn der Übertragung keine fehlerfreie Datenübertragung möglich ist, werden Einschwingzeiten von mehreren ms üblicherweise toleriert.

Um ein fehlerfreies Arbeiten der Übertragungsstrecke zu gewährleisten, muß vor der Übertragung von Daten ein Synchronisiersignal (Präambel) gesendet werden, dessen Dauer größer als die vom Empfänger vorgegebene Einschwingzeit ist, und das es dem Empfänger ermöglicht, seine Amplitudenregelung an den Pegel des Empfangssignals anzupassen. Bei großer Länge der übertragenen Datenblöcke fällt die Länge des Synchronisiersignals prozentuell nicht ins Gewicht.

Die binären Datensignale, die über eine optische Übertragunsstrecke gesendet werden sollen, werden üblicherweise vor der Übertragung kodiert. Die Kodierung ermöglicht Erkennung und Korrektur von Übertragungsfehlern. außerdem gewährleistet sie ein im Mittelwert gleichspannungsfreies elektrisches Signal nach dem Detektor und eine ausreichende Arizahl von Übergängen zwischen den logischen Pegeln, um die Taktinformation aus dem Signal unterbrechungsfrei rückgewinnen zu können.

Der Übertragungscode 'mBnB' weist jeweils einer Gruppe von m Datenbits ein Wort mit der Länge n bit zu. Je nach Code ist die Gleichspannungsfreiheit innerhalb von einem oder von zwei Worten garantiert. Die Gleichspannungsfreiheit erleichtert das Design des Empfängers, indem sie Wechselspannungskopplung zwischen den Verstärkerstufen ermöglicht. Die Zeitkonstante τc der Wechselspannungskopplung muß aber ausreichend lang gewählt sein, sodaß innerhalb der nicht gleichspannungsfreien Perioden von ein oder zwei Worten eine Signalverschiebung vermieden wird.

Zur Erläuterung des Standes der Technik wird auf die Fig. 1 bis 3 verwiesen. Dabei zeigen:
Fig. 1 ein Beispiel eines Netzwerkes mit Doppelsternstruktur,
Fig. 2a einen Idealfall eines typischen Empfangssignales,
Fig. 2b ein praktisch zu erwartendes Signal, bei dem die Signalblöcke unterschiedlicher Dämpfung unterworfen sind,
Fig. 3a ein Diagramm der Lichtleistung an einem Detektor des Empfängers und
Fig. 3b den Spannungsverlauf an einer Entscheiderstufe eines wechselspannungsgekoppelten Empfängers nach einem Sprung in der Amplitude des Empfangssignals.

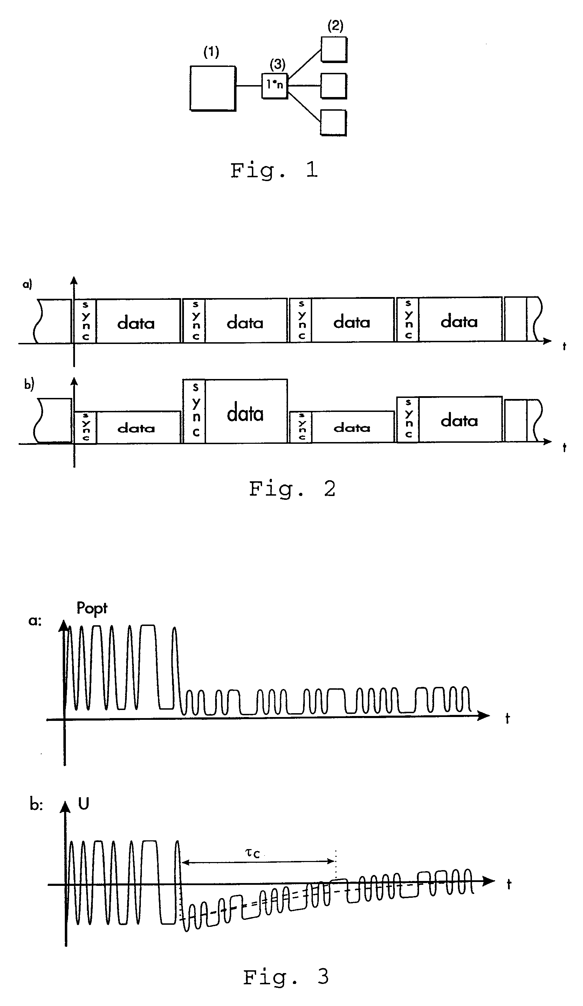

Die Situation bei passiven optischen Netzwerken nach der Fig. 1 in der Richtung von den peripheren Stationen (2) zur Hauptstation (1) (Aufwärtsrichtung) unterscheidet sich grundsätzlich von der Situation bei Punkt - zu - Punkt - Verbindungen. Hier wird durch die physikalische Kombinierfunktion der optischen Strahlteiler (3) das Signal von allen peripheren Stationen zum Empfänger der Hauptstation geleitet. Um Datenkollisionen zu vermeiden, senden die peripheren Stationen abwechselnd in kurzen zeitversetzten Paketen. Fig. 2 zeigt ein typisches Empfangssignal an der Hauptstation. Fig. 2a stellt den Idealfall dar, Abb. 2b zeigt ein praktisch zu erwartendes Signal, bei dem die Signalblöcke unterschiedlicher Dämpfung unterworfen sind.

Zwischen den von den einzelnen peripheren Stationen (2) gesendeten Signalblöcken sind Schutzzeiten vorgesehen, um bei Laufzeitunsicherheiten Signalübelappungen zu vermeiden. Die Amplitude und die Phasenlage. mit der das von den einzelnen peripheren Stationen gesendete Signal bei der Hauptstation ankommt, wird durch unterschiedliche Dämpfung und Laufzeit auf den verschiedenen optischen Pfaden beeinflußt . Damit an der Hauptstation ein Signal mit gleichmäßigem Pegel empfangen werden kann, werden diese Dämpfungsunterschiede durch entsprechende Einstellung der Sendepegel kompensiert. Aufgrund verschiedener Rauschprozesse verbleibt aber dennoch eine gewisse Unsicherheit der Empfangsamplitude, wodurch eine Anpassungsfähigkeit des Empfängers an Pegelschwankungen nach wie vor erforderlich ist. Zusätzlich muß der Empfänger auch nach einer längeren Unterbrechung des Empfangssignals nach möglichst kurzer Einschwingzeit wieder korrekt detektieren.

Wenn der Empfänger mit einer fixen Entscheidungsschwelle arbeitet, wie dies beispielsweise in Fig. 3b mit der Nullinie dargestellt ist, tritt eine relativ lange Einschwingzeit auf, die zur Zeitkonstante τc der Wechselstromankopplung proportional ist (der genaue Zusammenhang zwischen Einschwingzeit und Zeitkonstante ist von der Signalform, dem Rauschen und der tolerierten Erhöhung der Bitfehlerrate abhängig). Aus den oben erwähnten Gründen kann τc nicht beliebig klein gemacht werden, und die Forderung, daß die Einschwingzeit kleiner als die Dauer des Synchronisiersignals sein muß, läßt sich nur mit langen Synchronisiersignalen erfüllen.

Um mit kürzeren Synchronisiersignalen arbeiten zu können, kann man die Entscheidungsschwelle mittels eines Basislinienregenerators dem empfangenen Signal nachführen. Dabei ergibt sich jedoch der Nachteil eines sehr hohen Aufwandes für die erforderliche Elektronik des Empfängers.

Ziel der Erfindung ist es, diese Nachteile zu vermeiden und einen Empfänger der eingangs erwähnten Art vorzuschlagen, der trotz eines einfachen Aufbaus keine sehr langen Synchronisiersignale erfordert.

Erfindungsgemäß wird dies dadurch erreicht, daß die Wechselspannungs-Koppelstufe des Empfängers ein Zeitglied mit veränderbarer Zeitkonstante aufweist.

Durch diese Maßnahmen ist es möglich, mit kurzen Synchronisiersignalen das Auslangen zu finden, wobei eben während des Einlangens des Synchronisiersignales eine kurze Zeitkonstante des Zeitgliedes vorgesehen werden kann, wodurch es zu einem raschen Einschwingen des Empfängers auf eine geänderte Signalamplitude kommt.

Weiters kann vorgesehen sein, daß das Zeitglied von einer Steuerschaltung gesteuert ist, welche ein das Zeitglied steuerndes Signal abgibt.

Auf diese Weise kann sichergestellt werden, daß beim Einlangen eines Datenpaketes eine kleine Zeitkonstante bei dem Zeitglied mit veränderbarer Zeitkonstante eingestellt wird. Treffen nach dem Ende des Synchronisiersignales die Datensignale ein, die erst bei einer Betrachtung über eine längere Zeit gleichspannungsfrei sind, so wird die Zeitkonstante erhöht.

Nach einem weiteren Merkmal der Erfindung kann vorgesehen sein, daß das Zeitglied ein R/C-Glied sowie ein im ohm'schen Bereich arbeitendes Element. vorzugsweise einen Feldeffekttransistor, umfaßt. der von einer mit seinem Steueranschluß verbundenen Signalformerschaltung gesteuert ist, die von der Steuerschaltung ansteuerbar ist.

Ein weiteres Merkmal der Erfindung ist es, daß das Zeitglied eine vorzugsweise zwischen zwei festen Werten kontinuierlich veränderbare Zeitkonstante aufweist. Dadurch ist ein schleifender Übergang der Zeitkonstante möglich, wodurch die Entscheidungsschwelle mit einem nur sehr geringen Restfehler behaftet ist.

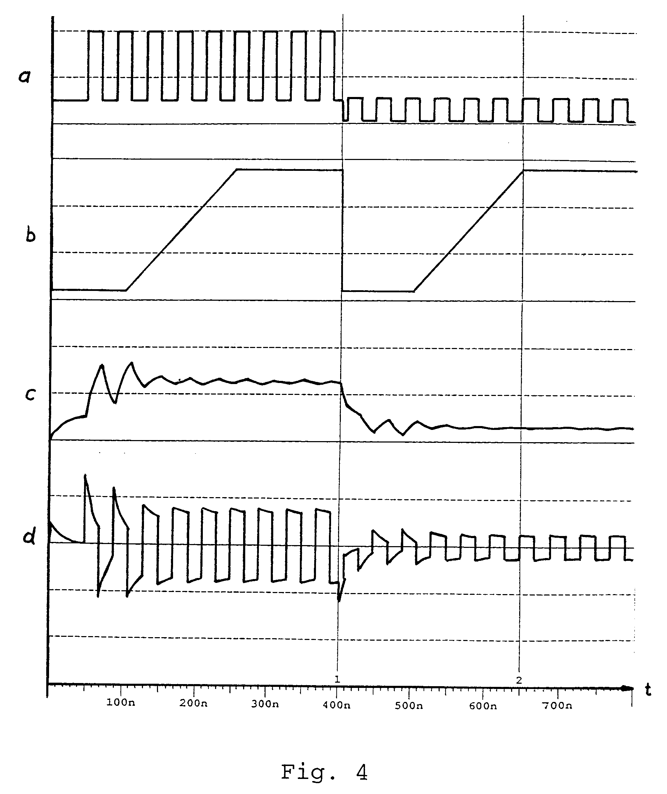

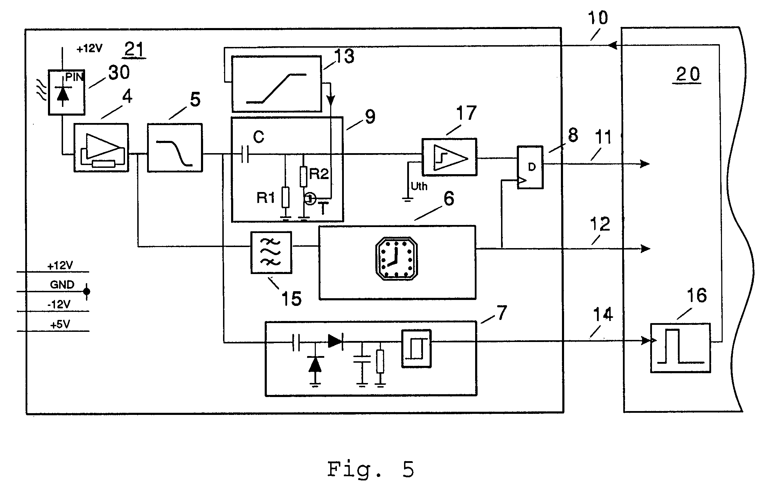

Die Erfindung wird nun anhand der Fig. 4 und 5 erläutert, wobei von einer Anordnung eines optischen Netzwerkes nach der Fig. 1 ausgegangen wird. Dabei zeigen:
Fig. 4a bis 4d die Simulation eines Einschwingvorganges nach einem Übergang zwischen zwei unterschiedlich gedämpften Signalblöcken, bei dem die Zeitkonstante veränderbar ist und
Fig. 5 ein Blockschaltbild eines optischen Empfängers mit veränderbarer Zeitkonstante.-

Wie aus der Fig. 5 zu ersehen ist, weist der Empfänger 21 einen PIN-Fotodetektor 30 auf. Diesem ist ein Transimpedanzverstärker 4 mit fixer Verstärkung nachgeschaltet. An den Ausgang des Transimpedanzverstärker 4 sind drei Zweige angeschlossen.

In dem einen Zweig ist eine Signalerkennungsschaltung 7 angeordnet, die ein Signal durch Überschreitung einer Minimalamplitude erkennt. Bei Vorhandensein eines Signales am Eingang der Signalerkennungsschaltung 7, gibt diese ein "Signal-detektiert"-Signal über eine Leitung 14 an eine flankengetriggerte Monoflop-Schaltung 16 ab.

In einem weiteren Zweig ist ein Bandpaßfilter 15 angeordnet, dem eine Taktregenerierschaltung 6 nachgeschaltet ist. Diese Schaltung 6 regeneriert das Taktsignal 12.

Im dritten Zweig ist ein Zeitglied 9 mit veränderbarer Zeitkonstante angeordnet, dem ein Komparator 17 nachgeschaltet ist, der das Ausgangssignal des Zeitgliedes 9 mit einem die Nullinie des Signales bestimmenden Potential vergleicht. Diesem Komparator 17 ist ein D-Flip-Flop 8 nachgeschaltet, dessen einer Eingang mit dem Ausgang der Taktregenerierschaltung 6 verbunden ist. Dieses D-Flip-Flop 8 tastet das Ausgangssignal des Komparators 17 zu den idealen Abtastzeitpunkten ab und liefert das Datensignal 11, das einer Steuereinheit 20 zugeführt wird.

Zwischen dem Ausgang des Transimpedanzverstärkers 4 und dem Eingang des Zeitgliedes 9 ist weiters ein Tiefpaß 5 zwischengeschaltet.

Das Zeitglied 9 besteht im wesentlichen aus einem R/C-Glied C, R1, wobei parallel zum Widerstand R1 eine Serienschaltung eines weiteren Widerstandes R2 und eines im ohm'schen Bereich arbeitenden Feldeffekttransistors T geschaltet ist. Die Steuerelektrode des Feldeffekttransistors T ist von einer Signalformerschaltung 13 gesteuert, die es ermöglicht, das Ausgangssignal des flankengetriggerten Monoflops 16, das als Zeitkonstantenumschaltsignal 10 dient, in einen analogen Kurvenzug umzuwandeln. Dieses analoge Signal steuert den Feldeffekttransistor T und damit den Gesamtwiderstand des Zeitgliedes 9 und damit die Zeitkonstante desselben.

Der in der Fig. 5 dargestellte Empfänger besitzt daher keine fixe Zeitkonstante τ_{c}, sondern die Zeitkonstante kann mittels des erwähnten Zeitkonstantenumschaltsignals 10 kontinuierlich zwischen zwei Werten τ_{c1} und τ_{c2} verändert werden. Dabei ist τ_{c1} eine sehr kurze Zeitkonstante und ermöglicht ein rasches Einschwingen des Empfängers auf eine geänderte Signalamplitude. Da sich der Arbeitspunkt des Empfängers aber bei Betrieb mit τ_{c1} während der Übertragung von Daten zu schnell verschieben würde, ist τ_{c1} nur zum Empfang des auch über sehr kurze Zeiträume gleichspannungsfreien Synchronisiersignales geeignet.

τc2 ist eine längere Zeitkonstante, die ausreichend lang gewählt sein muß, um innerhalb der nicht gleichspannungsfreien Perioden von ein oder zwei Worten eine Signalverschiebung zu vermeiden. Ein rechtzeitiges Einschwingen des Empfängers ist, wenn er ständig mit τc2 arbeitet, nur bei Verwendung wesentlich längerer Synchronisiersignale möglich.

Am Anfang eines Zeitschlitzes oder Datenpakets wird auf τc1 geschaltet. Die Umschaltung auf τc2 muß rechtzeitig vor Ende des Synchronisiersignals und damit vor Beginn der Datenübertragung erfolgen. Ein schleifender Übergang der Zeitkonstante ist vorteilhaft, weil dadurch die Spannung am Koppelkondensator C und damit die Entscheidungsschwelle zu Beginn der Datenübertragung mit einem wesentlich kleineren Restfehler behaftet ist als bei abruptem Übergang. Im Wartezustand (kein Signal) wird der Empfänger zweckmäßigerweise auf τc2 geschaltet, was aber für die Funktion des Empfängers nicht unbedingt notwendig ist.

Wenn die Dynamik des Komparators 17 und der Taktregenerierschaltung 6 größer als die zu erwartenden Pegelschwankungen sind, kann auf eine Amplitudenregelung des Signals mittels einer automatischen Verstärkungssteuerung verzichtet werden.

Fig. 4 zeigt die Simulation eines Einschwingvorganges nach einem Übergang zwischen zwei unterschiedlich gedämpften Signalblöcken, bei dem die Koppelzeitkonstante nach dem oben beschriebenen Prinzip verändert wird.

Fig. 4a: Zeitlicher Verlauf der optischen Eingangsleistung bzw. der Spannung am Ausgang des Transimpedanzverstärkers. Zum Zeitpunkt tl=400ns tritt ein Sprung sowohl in der Signalamplitude als auch im vertikalen Versatz des Signals (Gleichlicht) auf. Die Länge des Synchronisiersignals beträgt 250ns. Nach dieser Zeit sollte der Empfänger eingeschwungen und zum Empfang von Daten bereit sein.

Fig. 4b: Größe der Koppelzeitkonstante. Die Zeitkonstante wird zum Zeitpunkt t1 auf τc1 gesetzt und verbleibt für 100ns auf diesem Wert. Zwischen 500 und 650ns steigt die Zeitkonstante kontinuierlich und erreicht den Wert τc2 zum Zeitpunkt t2=650ns.

Fig. 4c: Spannung zwischen den Anschlüssen des Koppelkondensators D (Fig. 5). Die Spannung schwankt in Abhängigkeit von der Zeitkonstante und der Signalamplitude. Während der Präambel erreicht die Spannung schnell den Mittelwert des Eingangssignals. Die Schwankungen nehmen mit steigender Zeitkonstante ab. Während des Empfangs von Daten sollten sie möglichst klein im Verhältnis zur Signalamplitude sein.

Fig. 4d: Eingangssignal der Entscheiderstufe. Das Signal ist während der Präambel stark verzerrt und nähert sich schnell der Nullinie. Ab dem Zeitpunkt t2 treten nur noch minimale Verzerrungen auf.

Der Beginn eines Signalblocks nach einer Signalunterbrechung kann aus dem Signal 'Signal_detektiert' erkannt werden, das im Empfänger abgeleitet wird. Da die Signalblöcke aber auch ohne Unterbrechung aufeinanderfolgen können, ist die Erkennung des Beginns eines Signalblocks nicht immer in der physikalischen Schicht des Empfängers möglich, sondern der Zeitpunkt des Signalblock-Beginns muß in einem solchen Fall von einer digitalen Steuereinheit aus der im Protokoll festgelegten Abfolge der Signalblöcke errechnet werden.

Die Dauer, für die die Zeitkonstante des Empfängers auf τc1 bleibt, kann durch eine Zeitgeberschaltung oder ebenfalls von der digitalen Steuereinheit bestimmt werden.

Es sind prinzipiell drei Methoden denkbar, nach denen die Steuerung der Zeitkonstante ablaufen kann.
1) Steuerung über die Steuereinheit und das 'Signal_detektiert' - Signal des Empfangsteils:
   Im Regelfall kann der Beginn jedes Signalblocks durch die Steuereinheit vorhergesagt werden. Beim 'Hochfahren' des Systems (hier findet beispielsweise das im Stand der Technik beschriebene Zuordnungs- und Rangingverfahren statt) kann die Steuereinheit aber den Beginn der ankommenden Signalblöcke nicht vorhersagen, da die Signallaufzeiten und die Zuordnung der Stationen im System noch nicht bekannt sind. In diesem Betriebszustand des Systems kann der Beginn der Signalblöcke aber physikalisch im Empfänger erkannt werden.
   Die Umschaltung des Empfängers auf die kurze Zeitkonstante wird also im normalen Betrieb durch die Vorhersage des Beginns eines Signalblocks durch die Steuereinheit ausgelöst, während des Rangingverfahrens aber durch eine ansteigende Flanke des 'Signal_detektiert' - Signals aus dem Empfänger, das an die Steuereinheit weitergegeben wird.
   Die unmittelbare Steuerung der Zeitkonstantenumschaltung erfolgt stets durch die Steuereinheit.
2) Steuerung über das 'Signal_detektiert' - Signal des Empfangsteils ohne Unterstützung durch die Steuereinheit:
   In manchen Fällen werden die nach der Korrektur der Sendepegel verbleibenden Amplitudenschwankungen sehr gering sein, speziell bei Netzwerken, die mit Einmodenfasern und auf Wellenlängen um 1300 und/oder 1550 Nanometer arbeiten. In diesem Fall kann der Empfänger bei einem unterbrechungsfreien Übergang zwischen zwei Signalblöcken auf τc2 verbleiben, da kein erneuter Einschwingvorgang stattfinden muß.
   Es ist daher in diesem Fall möglich, die Umschaltung nur durch das 'Signal_detektiert' - Signal des Empfangsteils und eine einfache Zeitgeberschaltung erfolgen zu lassen. Nach jedem detektierten Beginn eines Signalblocks wird die Zeitkonstante für die (fixe) Dauer des Synchronisiersignals auf τc1 gesetzt, dann auf τc2 umgeschaltet und verbleibt auf τc2, bis der nächste Beginn eines Signalblocks erkannt wird.
3) Steuerung ausschließlich durch die digitale Steuereinheit der Hauptstation:
   Beim Initialisieren des Systems kann die Steuereinheit Beginn und Ende der ankommenden Signalblöcke nicht vorhersagen. In diesem Betriebszustand des Systems muß die Zeitkonstante des Empfängers auf τc2 gesetzt sein, um eine Erkennung der gesendeten Daten (Stationskennungen) zu ermöglichen. Der dadurch erhöhten Einschwingzeit muß durch verlängerte Synchronisiersignale Rechnung getragen werden.
   Wenn das System im normalen Betrieb arbeitet, werden kurze Synchronisiersignale übertragen. Der Empfänger wird während der Synchronisierzeiten auf τc1 und sonst immer auf τc2 geschaltet.

## Patentansprüche

1. Empfänger für ein optisches Übertragungsnetzwerk mit einer Zentralstelle, an die wenigstens ein Lichtweilenleiter angeschlossen ist, an welchen über wenigstens einen Strahlenteiler und weitere Lichtwellenleiter eine Anzahl von mit jeweils einem Sender und einem Empfänger für optische Binärsignale versehene Endstellen angeschlossen sind, und der Empfänger der Zentralstelle eine Wechselspannungs-Koppelstufe umfaßt, **dadurch gekennzeichnet,** daß ein aus Synchron- und anschließenden Datenimpulsen bestehendes Impulssignal zum schnellen Einschwingen der Datenimpulse nach den Synchronimpulsen einem Zeitglied (9) zugeleitet wird, welchem Zeitglied vorerst eine erste, kleine Zeitkonstante und dann eine zweite, große Zeitkonstante zugeordnet wird.

2. Empfänger nach Anspruch 1, **dadurch gekennzeichnet**, daß das Zeitglied (9) von einer Steuerschaltung (7) gesteuert ist, welche ein das Zeitglied (9) steuerndes Signal (10) abgibt.

3. Empfänger nach Anspruch 1 oder 2, **dadurch** **gekennzeichnet,** daß das Zeitglied (9) ein R/C-Glied sowie ein im ohm'schen Bereich arbeitendes Element (T), vorzugsweise einen Feldeffekttransistor, umfaßt, der von einer mit seinem Steueranschluß verbundenen Signalformerschaltung (13) gesteuert ist, die von der Steuerschaltung (7) ansteuerbar ist.

4. Empfänger nach Anspruch 1 oder 2, **dadurch** **gekennzeichnet,** daß das Zeitglied (9) beim Übergang zwischen der ersten auf die zweite Zeitkonstante eine vorzugsweise zwischen diesen beiden Werten kontinuierlich veränderbare Zeitkonstante aufweist.

5. Empfänger nach Anspruch 4, **dadurch gekennzeichnet**, daß der Übergang zwischen der ersten und der zweiten Zeitkonstante linear nach der Zeit ansteigend erfolgt.
